# FASCICULE DE BREVET EUROPEEN

(11) **EP 0 762 658 B1**
(45) Date de publication et mention de la délivrance du brevet: **14.03.2001**
(21) Numéro de dépôt: 96460028.2
(22) Date de dépôt: 09.08.1996
(51) Int. Cl.: H03M 7/30, H03M 7/42, H04N 7/30

(54) **Procédé de codage de données numériques représentées par des vecteurs et procédé de décodage des données codées selon ledit procédé de codage**
Verfahren zur Kodierung von durch Vektoren dargestellten digitalen Dateien und geeignete Dekodierungsverfahren
Method for coding vectorial digital data and associated decoding method

(30) Priorité: 11.08.1995 FR 9509902
(43) Date de publication de la demande: 12.03.1997
(73) Titulaire: FRANCE TELECOM, 75015 Paris (FR); TELEDIFFUSION DE FRANCE S.A., 75015 Paris (FR)
(72) Inventeur: Guillemot, Christine, 35000 Rennes (FR); Onno, Patrice, 35510 Cesson-Sevigne (FR)
(74) Mandataire: Maillet, Alain

(56) Documents cités:
- EP-A- 0 283 715
- EP-A- 0 450 937
- US-A- 5 473 376
- IEEE JOURNAL ON SELECTED AREAS IN COMMUNICATION, vol. 10, no. 5, Juin 1992, NEW YORK US, pages 892-901, XP002019113 WANG ET AL: "unified variable length transform coding and image-adaptive vector quantization"
- ANNALES DES T L COMMUNICATIONS, vol. 46, no. 7-8, 7 Août 1991, pages 452-459, XP002019114 DELOGNE ET AL: "universal variable length coding for an integrated approach to image coding"

## Description

La présente invention concerne un procédé de codage de données numériques réprésentées par des vecteurs. Ces vecteurs sont par exemple les vecteurs mouvement ou les vecteurs issus d'une étape de quantification vectorielle sur réseau. Ce procédé de codage est destiné à être appliqué dans des procédés de compression de données numériques, en particulier, de données représentatives d'images fixes ou animées.

Elle concerne également un procédé de décodage des données qui sont codées selon le procédé de codage mentionné ci-dessus.

Dans un procédé de compression d'images fixes, l'opération de compression est réalisée lors d'une étape de quantification et d'une étape de codage entropique subséquente. L'opération de quantification s'applique à l'image elle-même ou à des sous-images qui résultent d'une transformation de l'image de départ. La quantification peut être soit scalaire et elle s'applique alors à chaque pixel de l'image ou de chaque sous-image indépendamment les uns des autres, soit vectorielle et elle s'applique à un groupe de pixels.

L'opération de quantification vectorielle consiste à rechercher, pour chaque groupe de pixels, un vecteur approprié et l'opération de codage consiste à déterminer un code qui soit représentatif de ce vecteur.

La quantification d'un vecteur peut être réalisée en exploitant un dictionnaire stocké obtenu par une approche statistique. Cette approche est indiquée quand la distribution des vecteurs à quantifier est franchement non-uniforme.

Une autre approche, dite quantification algébrique, consiste à utiliser un réseau régulier de points puis à projeter les vecteurs à quantifier sur ce réseau afin de déterminer les vecteurs quantifiés. Dans la pratique, on utilise un réseau de points qui est le plus compact possible. Cette approche sera appropriée dans le cas où les orientations des vecteurs sont raisonnablement et uniformément distribuées sur le réseau de points.

L'opération de codage qui fait suite à une opération de quantification avec dictionnaire indexé consiste, d'une part, à attribuer un code à chaque index du dictionnaire puis, d'autre part, à rechercher dans le dictionnaire le code correspondant à l'index du vecteur quantifié.

Une telle technique, même si elle pouvait être appliquée suite à une opération de quantification vectorielle sur réseau, serait d'un point de vue performances beaucoup plus coûteuse en temps de calcul. Comme le réseau est figé et possède un maillage régulier, il est intéressant de pouvoir attribuer des mots de code en fonction de la statistique des vecteurs quantifiés. La meilleure façon est d'attribuer des mots de courte longueur aux vecteurs les plus probables et des mots longs aux moins fréquents. Ces techniques couramment utilisées en codage d'images effectuent ce que l'on appelle un codage entropique de l'information.

Dans la pratique, pour affecter un mot de code à un vecteur du réseau, on élabore deux codes distincts: l'un correspond à la norme du vecteur sur le réseau et l'autre à un indice sur l'isonorme auquel il appartient. Cette manière de procéder consiste en quelque sorte à réaliser une représentation polaire du vecteur considéré. Dans la plupart des cas, on entreprend un codage entropique de type "Huffman" sur les isonormes. De même, pour les indices, on réalise un codage entropique en faisant l'hypothèse que, sur une isonorme, la probabilité d'apparition des indices est constante.

Ce type de codage donne entière satisfaction notamment si l'on considère le rapport signal sur bruit engendré pour un débit donné.

Le but de l'invention est néanmoins de proposer un procédé de codage des vecteurs issus de l'étape de quantification ou des vecteurs de mouvement dans le cas du codage de séquences d'images animées qui permette d'améliorer encore le rapport signal sur bruit engendré pour un même débit ou de diminuer le débit pour un rapport signal sur bruit donné.

Pour ce faire, un procédé de codage de vecteurs d'un espace de dimension n selon l'invention est caractérisé en ce qu'il consiste à affecter à chacun des vecteurs un code représentatif de sa norme, un code d'appartenance à un type de vecteurs, chaque type étant défini par une relation donnée pouvant exister entre les valeurs prises par les composantes des vecteurs à coder, et d'un code d'indice différenciant ledit vecteur des autres vecteurs de même norme et de même type.

Pour définir chaque type, il consiste avantageusement à constituer des sous-ensembles de l'ensemble des vecteurs à coder de même norme, chacun desdits sous-ensembles étant formé des vecteurs dont les composantes comprennent un ou plusieurs multiplets présentant des caractéristiques prédéterminées. Par exemple, chacun desdits sous-ensembles est formé des vecteurs dont les composantes comprennent un ou plusieurs multiplets dont les éléments se déduisent les uns des autres selon un rapport prédéterminé ou dont les éléments sont égaux entre eux.

Lorsque lesdits vecteurs à coder sont de dimension quatre, le procédé de l'invention consiste, pour définir chaque type de vecteurs, à constituer des sous-ensembles de vecteurs de la manière suivante:
- le premier type correspond au sous-ensemble des vecteurs dont les quatre composantes sont égales,
- le deuxième type correspond au sous-ensemble des vecteurs dont les composantes présentent deux couples de composantes identiques,
- le troisième type correspond au sous-ensemble des vecteurs dont les composantes présentent un couple de composantes identiques et un couple de composantes différentes,
- le quatrième type correspond au sous-ensemble des vecteurs dont les composantes présentent un triplet de composantes identiques et une composante différente, enfin
- le cinquième type correspond au sous-ensemble des vecteurs dont les composantes sont deux à deux différentes.

La présente invention concerne également un procédé de décodage de données numériques représentatives des composantes d'un vecteur d'un espace de dimension n, lesdites composantes étant elles-mêmes représentatives des valeurs prises par un signal à recouvrer.

Conformément au procédé de codage évoqué plus ci-dessus, lesdites données comportent un code de norme déterminant la norme dudit vecteur, un code d'appartenance dudit vecteur à un type de vecteurs, et un code d'indice différenciant ledit vecteur des autres vecteurs de même norme et de même type.

L'opération de codage consiste à:
- déterminer un ensemble de points dudit espace, lesdits points appartenant à une isonorme dont la norme est donnée par ledit code de norme,
- déterminer un sous-ensemble de points dudit ensemble de points, lesdits points dudit sous-ensemble étant définis par leur appartenance à un type donné par ledit code de type,
- déterminer le point de l'espace qui appartient audit sous-ensemble et qui possède ledit code d'indice,
- considérer les composantes dudit vecteur pour recouvrer la valeur du signal à recouvrer.

Les caractéristiques de l'invention mentionnées ci-dessus, ainsi que d'autres, apparaîtront plus clairement à la lecture de la description suivante faite en relation avec les dessins joints, parmi lesquels:
la Fig. 1 est un schéma synoptique d'un procédé de compression de données utilisant un procédé de codage selon l'état de la technique,
la Fig. 2 est un schéma synoptique d'un procédé de compression de données utilisant un procédé de codage selon l'invention, et
la Fig. 3 est un tableau montrant les types affectés à cent vecteurs de dimension 4 appartenant à un réseau D₄.

De manière générale, un procédé de codage du type qui fait l'objet de l'invention est prévu pour délivrer des codes représentant biunivoquement des vecteurs, c'est-à-dire des grandeurs qui présentent plusieurs dimensions. Ces vecteurs sont par exemple des vecteurs de mouvement calculés dans une étape d'estimation de mouvement d'un procédé de compression d'images animées.

Il peut également s'agir de vecteurs issus d'une étape de quantification vectorielle sur réseau. Ce dernier cas est choisi à titre d'exemple pour illustrer le procédé de codage de l'invention.

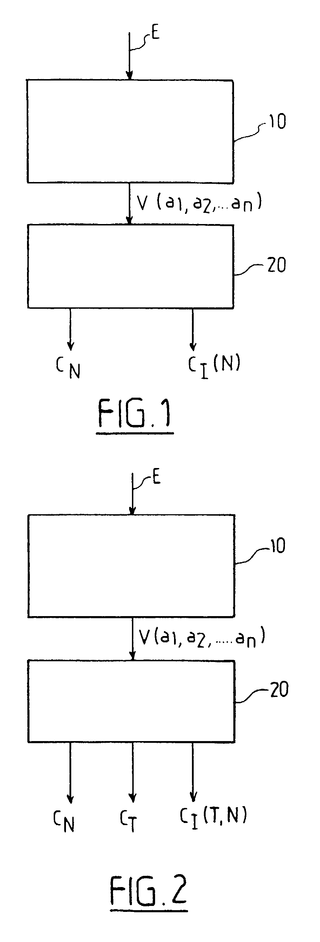

On a représenté à la Fig. 1 une étape de quantification 10 qui permet de quantifier en un point d'un réseau associé dans un espace de dimension n un vecteur, dit vecteur à quantifier, dont les composantes sont des valeurs prises par les signaux d'entrée E. Ces signaux sont par exemple des signaux d'images dans une sous-bande donnée pour un groupement de n pixels.

Le résultat de cette étape de quantification 10 est donc un point du réseau qui est le plus proche voisin du vecteur à quantifier. Ce point du réseau est représenté par un vecteur v(a₁,a₂,...,aₙ) dans un espace de dimension n.

On notera que le procédé de l'invention s'applique à tout type de réseaux qui peuvent être du type Zₙ, Aₙ, Dₙ, Eₙ ou ₙ et de dimension quelconque.

Dans un procédé de l'état de la technique, pour effectuer le codage de ce vecteur (étape référencée 20), on élabore un code produit formé d'un code C_{N} représentatif de la norme du vecteur considéré et d'un code C_{I}(N) qui est défini par un indice attribué à chaque vecteur pour le différencier des autres vecteurs de même norme N. Généralement, pour chaque point, les codes de norme et d'indice C_{N} et C_{I}(N) sont des codes entropiques, tels que des codes d"'Huffman". La norme utilisée peut être du type L₁ ou L₂, les isonormes (ensembles de points engendrés par des vecteurs de même norme) étant respectivement des hyperpyramides ou des hypersphères.

Le procédé de codage de l'invention se distingue du procédé décrit succinctement ci-dessus en ce qu'il consiste à affecter à chacun des vecteurs un code C_{N} représentatif de sa norme (voir Fig. 2), un code C_{T} d'appartenance à un type de vecteurs et d'un code C_{I}(N, T) le différenciant des autres vecteurs de même norme N et de même type T. Un type de vecteurs est défini, de manière générale, par une relation donnée pouvant exister entre les valeurs prises par les composantes des vecteurs à coder et permet au codage de prendre en compte la corrélation qui peut exister entre les composantes des vecteurs à coder.

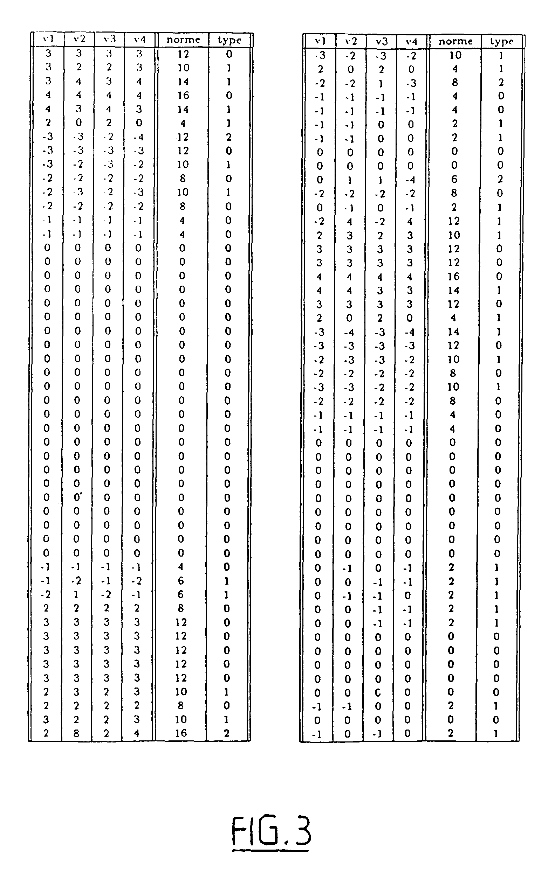

Si l'on considère les cent vecteurs tabulés à la Fig. 3 qui sont issus d'une étape de quantification de signaux d'une bande basse fréquence, on peut observer que ces vecteurs ont leurs composantes très corrélées et ceci n'est pas du tout mis à profit dans le procédé de codage de l'art antérieur décrit ci-dessus.

Pour tenir compte de cette corrélation et donc pour définir chaque type de vecteurs, on fait une partition de l'ensemble des vecteurs appartenant à une même isonorme en plusieurs sous-ensembles, chacun desdits sous-ensembles étant formé des vecteurs dont les composantes comprennent un ou plusieurs multiplets présentant des caractéristiques prédéterminées.

Par multiplet, on entend le résultat d'une association des composantes des vecteurs, par exemple des couples de composantes, des triplets de composantes, etc.

Selon l'invention, à l'intérieur d'un même type, les composantes des vecteurs comprennent un ou plusieurs multiplets dont les éléments se déduisent les uns des autres selon un rapport prédéterminé ou dont les éléments sont égaux.

Dans la suite de la description, on ne considère que le cas où les éléments des multiplets formés par les composantes des vecteurs sont égaux mais on comprendra que l'invention n'est pas limitée à ce cas particulier.

Dans le cas du réseau D₄, il y a exactement cinq types qui sont alors définis de la manière suivante:
- le premier type correspond au sous-ensemble des vecteurs dont les quatre composantes sont identiques,
- le deuxième type correspond au sous-ensemble des vecteurs dont les composantes présentent deux couples de composantes identiques,
- le troisième type correspond au sous-ensemble des vecteurs dont les composantes présentent un couple de composantes identiques et un couple de composantes différentes,
- le quatrième type correspond au sous-ensemble des vecteurs dont les composantes présentent un triplet de composantes identiques et une composante différente, enfin
- le cinquième type correspond au sous-ensemble des vecteurs dont les composantes sont deux à deux différentes.

Ces différents types pour le réseau D₄ sont récapitulés et illustrés d'un exemple dans le tableau ci-dessous.

| type | propriétés | exemple (norme *L*₁ = 4) |
|---|---|---|
| 0 | 4 composantes identiques | 1,1,1,1 |
| 1 | 2 composantes identiques + 2 composantes identiques | 2,2,0,0 |
| 2 | 2 composantes identiques + 2 composantes différentes | 2,1,1,0 |
| 3 | 3 composantes identiques + 1 composante seule | 4,0,0,0 |
| 4 | 4 composantes différentes | 2,1,0,-1 |

Le choix des types est entièrement lié à la dimension du réseau considéré mais elle est indépendante de la norme choisie. Ainsi pour un vecteur appartenant à un réseau régulier quelconque, il existe plusieurs types qui, par permutation, engendrent tous les vecteurs d'une isonorme. Par exemple, pour un réseau régulier de dimension 5 le nombre de types est de 7, pour un réseau de dimension 6, le nombre de types est de 11, etc.

On a représenté dans le tableau de la Fig. 3 les types de cent vecteurs de dimension 4 appartenant à un réseau D₄. On remarquera une forte probabilité des types 0 et 1 qui correspondent à des vecteurs très corrélés. Il est alors inutile de tenir compte des autres types de façon équivalente puisqu'ils sont peu représentés.

La répartition des types pour chaque valeur de norme offre des propriétés intéressantes pour le codage de signaux corrélés après quantification. Le dénombrement des vecteurs de chaque type en fonction des valeurs prises par la norme de ces vecteurs est donné dans le tableau ci-dessous pour un réseau de type D₄ de norme L₁.

| Isonorme | type 0 | type 1 | type 2 | type 3 | type 4 | total |
|---|---|---|---|---|---|---|
| 0 | 1 | 0 | 0 | 0 | 0 | 1 |
| 2 | 0 | 12 | 12 | 8 | 0 | 32 |
| 4 | 2 | 18 | 108 | 16 | 48 | 192 |
| 6 | 0 | 36 | 276 | 32 | 264 | 608 |
| 8 | 2 | 42 | 588 | 32 | 744 | 1408 |
| 10 | 0 | 60 | 924 | 56 | 1680 | 2720 |
| 12 | 2 | 66 | 1428 | 56 | 3120 | 4672 |
| 14 | 0 | 84 | 1980 | 72 | 5256 | 7392 |
| 16 | 2 | 90 | 2652 | 80 | 8184 | 11008 |
| 18 | 0 | 108 | 3396 | 96 | 12048 | 15648 |
| 20 | 2 | 114 | 4284 | 96 | 16944 | 21440 |
| 22 | 0 | 132 | 5196 | 120 | 23064 | 28512 |
| 24 | 2 | 138 | 6276 | 120 | 30456 | 36992 |
| 26 | 0 | 156 | 7404 | 136 | 39312 | 47008 |
| 28 | 2 | 162 | 8652 | 144 | 49728 | 58688 |
| 30 | 0 | 180 | 9972 | 160 | 61848 | 72160 |
| 32 | 2 | 186 | 11436 | 160 | 75768 | 87552 |
| 34 | 0 | 204 | 12924 | 184 | 91680 | 104992 |
| 36 | 2 | 210 | 14580 | 184 | 109632 | 124608 |
| 38 | 0 | 228 | 16284 | 200 | 129816 | 146528 |

On peut constater que les vecteurs de type 0 et de type 1 sont en minorité par rapport aux vecteurs de type 2, 3 et 4. On va donc, pour établir les codes de norme, de type et d'indice, tenir compte des répartitions statistiques et ainsi procéder à des codages entropiques, tels qu'un codage d'Huffman.

Le code généré pour représenter un vecteur va consister en trois codes construits de la manière suivante:
- un code C_{N} pour représenter l'isonorme à partir d'un code d'Huffman calculé suivant la statistique des isonormes. En réalité, rien ne change par rapport aux procédés de l'art antérieur.
- un code C_{T} pour donner le type du vecteur. La statistique est ici appliquée à l'ensemble des vecteurs ou à chaque isonorme. On obtient ainsi un code Huffman pour coder le type de chaque vecteur.
- un code C_{I}(N,T) pour indexer le vecteur ayant une norme codée par le premier code C_{N} et ayant pour type celui donné par le second code C_{T}. Ce code C_{I}(N, T) pourra être calculé en faisant l'hypothèse que les vecteurs issus de ce type sur cette isonorme ont la même probabilité d'apparition.

On va donner un exemple de codage selon le procédé de l'invention, à partir des cent vecteurs donnés dans le tableau de la Fig. 3.

Le tableau ci-dessous montre la longueur du code de norme C_{N} en fonction des valeurs prises par la norme. Le code utilisé est un code d'Huffman qui tient par conséquent compte de la fréquence de chaque "événement norme".

| | | | | | | | | | |
|---|---|---|---|---|---|---|---|---|---|
| événement "norme" | 0 | 2 | 4 | 6 | 8 | 10 | 12 | 14 | 16 |
| fréquence | 40 | 10 | 10 | 3 | 8 | 9 | 13 | 4 | 3 |
| long. du code "norme" | 1 | 3 | 4 | 6 | 4 | 4 | 3 | 5 | 6 |

Pour déterminer le type auquel appartient chaque vecteur, on range les composantes suivant un ordre croissant ou décroissant et on compte les composantes identiques. Pour déterminer la longueur de code des cinq "événements type" (cas du réseau D₄), un code d'Huffman est généré où l'on ne tient pas compte des cas où le vecteur est nul.

Le tableau ci-dessous donne la longueur du code de type C_{T} en fonction du type considéré et sa fréquence.

| | | | | | |
|---|---|---|---|---|---|
| événement "type" | 0 | 1 | 2 | 3 | 4 |
| fréquence | 26 | 28 | 4 | 2 | 0 |
| long. du code "type" | 1 | 2 | 3 | 3 | 0 |

On notera que si l'on ne fait pas intervenir les vecteurs nuls dans la statistique, c'est parce qu'ils sont entièrement définis par le code de norme 0.

On notera encore qu'un code à longueur variable tel que celui qui est décrit par P. DELOGNE et B. MACQ, d'une part, dans un article intitulé "Universal variable lenght coding for an integrated approach to image coding", paru dans ANN TELECOMMUN, 46, n° 7-8, 1991, et, d'autre part, dans le document de brevet EP-A-294 357 couramment nommé UVLC, permet d'atteindre, dans le cas d'événements ayant une entropie inférieure à 1 bit par point, un code plus adapté pour la norme et le type. De manière générale, un code entropique peut être choisi plutôt qu'un autre afin d'améliorer le codage des types.

Une fois le code de type déterminé, on code l'indice donnant le vecteur exact étant donné sa norme et son type. Le tableau ci-dessous donne la longueur des codes d'Huffman pour les indices des vecteurs ayant un type donné et une norme donnée.

| "type" - "norme" | 0 | 2 | 4 | 6 | 8 | 10 | 12 | 14 | 16 |
|---|---|---|---|---|---|---|---|---|---|
| 0 | 0 | 0 | 1.00 | 0 | 1.00 | 0 | 1.00 | 0 | 1.00 |
| 1 | 0 | 3.66 | 4.22 | 5.22 | 5.47 | 5.93 | 6.06 | 6.47 | 6.57 |
| 2 | 0 | 3.66 | 6.81 | 8.14 | 9.25 | 9.89 | 10.56 | 10.96 | 11.45 |
| 3 | 0 | 3.00 | 4.00 | 5.00 | 5.00 | 5.85 | 5.85 | 6.22 | 6.40 |

A titre d'exemple, si l'on considère un vecteur de norme 4 et de type 1 dans un réseau D₄, il sera codé avec sur une longueur moyenne de 10,22 bits soit, 4 + 2 + 4,22.

Par les procédés de l'art antérieur, il aurait nécessité un code de longueur 4 + 7,66 soit 11,66 bits.

On remarquera le grand gain apporté au codage des vecteurs ayant les types 0 et 1.

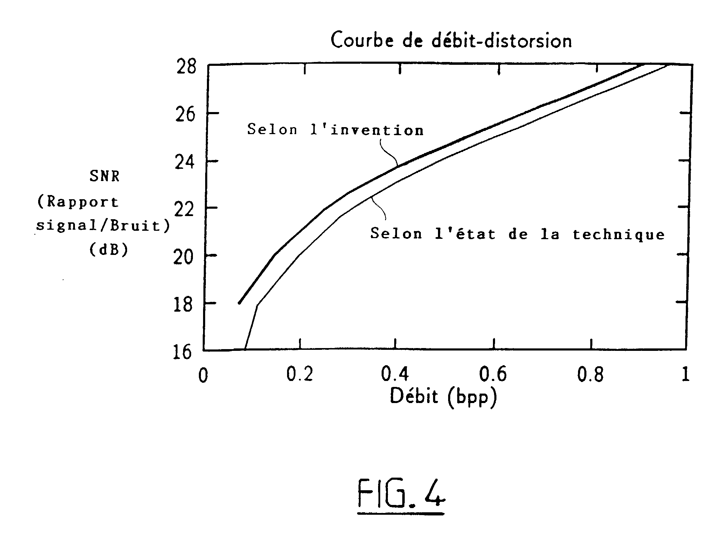

Le procédé de codage précédemment décrit a été introduit dans un schéma de codage d'images où l'on utilise une décomposition en sous-bandes et une quantification vectorielle sur réseau combinée à un algorithme de minimisation de distorsion sous contrainte d'un débit donné tel que celui qui est décrit, par K. Ramchandran et M. Vetterli dans un article paru dans IEEE Transactions on Image Processing d'avril 1993 et intitulé "Best wavelet packet bases in a rate-distorsion sense". La Fig. 4 montre le gain apporté par le présent procédé par rapport à un procédé de l'art antérieur où seuls les normes et indices de vecteurs sont codés. On peut constater qu'il permet d'atteindre près de 1 dB à bas débit.

La présente invention concerne également un procédé de décodage de données qui ont été codées selon les procédés décrits ci-dessus. Il consiste essentiellement à recouvrer, à partir des codes de normes C_{N}, de type C_{T} et d'indice C_{I}(N, T), les composantes du vecteur que ces codes représentent, puis de recouvrer les valeurs du signal codé. pour ce faire, il consiste à:
- déterminer un ensemble de points dudit espace, lesdits points appartenant à une isonorme dont la norme est donnée par ledit code de norme,
- déterminer un sous-ensemble de points dudit ensemble de points, lesdits points dudit sous-ensemble étant définis par leur appartenance à un type donné par ledit code de type,
- déterminer le point de l'espace qui appartient audit sous-ensemble et qui possède ledit code d'indice,
- considérer les composantes dudit vecteur pour recouvrer la valeur du signal à recouvrer.

Un intérêt des procédés de codage et de décodage de l'invention réside dans le fait qu'ils permettent de diminuer les temps de calcul nécessaires pour les mettre en oeuvre en comparaison aux procédés de l'art antérieur. Ces diminutions sont notamment attribuées aux étapes de codage et de décodage du code d'indexe C_{I}(N,T) car elles sont effectuées sur une partition de l'ensemble à coder.

L'invention n'est pas limitée à l'application qui est décrite. On comprendra que l'origine des vecteurs à coder est sans importance pour les procédés de l'invention.

Si cette origine est une étape de quantification, on comprendra également que cette étape pourrait être contrainte en débit comme cela a été mentionné ci-dessus.

## Revendications

1. Procédé de codage de données numériques représentées par des vecteurs d'un espace de dimension n dont les composantes sont représentatives des valeurs prises par un signal à coder, caractérisé en ce qu'il consiste à affecter à chacun des vecteurs un code (C_{N}) représentatif de sa norme, un code (C_{T}) d'appartenance à un type de vecteurs, chaque type étant défini par une relation donnée pouvant exister entre les valeurs prises par les composantes des vecteurs à coder, et d'un code d'indice (C_{I}(N, T)) différenciant ledit vecteur des autres vecteurs de même norme et de même type.

2. Procédé de codage selon la revendication 1, caractérisé en ce qu'il consiste, pour définir chaque type, à constituer des sous-ensembles de l'ensemble des vecteurs à coder de même norme, chacun desdits sous-ensembles étant formé des vecteurs dont les composantes comprennent un ou plusieurs multiplets présentant des caractéristiques prédéterminées.

3. Procédé de codage selon la revendication 1, caractérisé en ce qu'il consiste, pour définir chaque type, à constituer des sous-ensembles sous-ensembles de l'ensemble des vecteurs à coder, chacun desdits étant formé des vecteurs dont les composantes comprennent un ou plusieurs multiplets dont les éléments se déduisent les uns des autres selon un rapport prédéterminé.

4. Procédé de codage selon la revendication 1, caractérisé en ce qu'il consiste, pour définir chaque type, à constituer des sous-ensembles sous-ensembles de l'ensemble des vecteurs à coder, chacun desdits étant formé des vecteurs dont les composantes comprennent un ou plusieurs multiplets dont les éléments sont égaux entre eux.

5. Procédé de codage selon la revendication 4, lesdits vecteurs à coder étant de dimension quatre, caractérisé en ce qu'il consiste, pour former ledit code de type, à constituer des cinq types de sous-ensembles de la manière suivante:
- le premier type correspond au sous-ensemble des vecteurs dont les quatre composantes sont égales,
- le deuxième type correspond au sous-ensemble des vecteurs dont les composantes présentent deux couples de composantes identiques,
- le troisième type correspond au sous-ensemble des vecteurs dont les composantes présentent un couple de composantes identiques et un couple de composantes différentes,
- le quatrième type correspond au sous-ensemble des vecteurs dont les composantes présentent un triplet de composantes identiques et une composante différente, enfin
- le cinquième type correspond au sous-ensemble des vecteurs dont les composantes sont deux à deux différentes.

6. Procédé de décodage de données numériques représentatives des composantes d'un vecteur d'un espace de dimension n, lesdites composantes étant elles-mêmes représentatives des valeurs prises par un signal à recouvrer, lesdites données comportant un code de norme (C_{N)} déterminant la norme dudit vecteur, un code (C_{T)} d'appartenance dudit vecteur à un type de vecteurs, et un code d'indice (C_{I}(N, T)) différenciant ledit vecteur des autres vecteurs de même norme et de même type, caractérisé en ce qu'il consiste à:
- déterminer un ensemble de points dudit espace, lesdits points appartenant à une isonorme dont la norme est donnée par ledit code de norme (C_{N)},
- déterminer un sous-ensemble de points dudit ensemble de points, lesdits points dudit sous-ensemble étant définis par leur appartenance à un type donné par ledit code de type (C_{T)},
- déterminer le point de l'espace qui appartient audit sous-ensemble et qui possède ledit code d'indice (C_{I}(N, T)),
- considérer les composantes dudit vecteur pour recouvrer la valeur du signal à recouvrer.

## Claims

1. Method of coding digital data represented by vectors of a space of dimension n of which the components represent values assumed by a signal to be coded, **characterised in that** it consists in assigning to each of the vectors a code (C_{N}) representing its standard, a code (C_{T}) showing the type of vector, each type being defined by a given relationship able to exist between the values assumed by the components of the vectors to be coded, and of an index code (C_{I}(N,T)) differentiating said vector from the other vectors of the same standard and same type.

2. Coding method according to claim 1, **characterised in that** it consists in, in order to define each type, forming sub-sets of the set of vectors to be coded of the same standard, each of the said sub-sets being formed from vectors of which the components comprise one or more bytes having pre-determined characteristics.

3. Coding method according to claim 1, **characterised in that** it consists in, in order to define each type, forming sub-sets of the set of vectors to be coded, each of the said sub-sets being formed from vectors of which the components comprise one or more bytes of which the elements are deduced from one another according to a pre-determined relationship.

4. Coding method according to claim 1, **characterised in that** it consists in, in order to define each type, forming sub-sets of the set of vectors to be coded, each of the said sub-sets being formed from vectors of which the components comprise one or more bytes of which the elements are equal to one another.

5. Coding method according to claim 4, the said vectors to be coded being of dimension four, **characterised in that** it consists in, in order to form said type code, constituting five types of sub-sets in the following manner:
- the first type corresponds to the sub-set of the vectors of which the four components are equal,
- the second type corresponds to the sub-set of the vectors of which the components have two pairs of identical components,
- the third type corresponds to the sub-set of the vectors of which the components have a pair of identical components and a pair of different components,
- the fourth type corresponds to the sub-set of the vectors of which the components have a triplet of identical components and one different component, and finally
- the fifth type corresponds to the sub-set of the vectors of which the components are different, two by two.

6. Method of decoding digital data representing components of a vector of a space of dimension n, the said components themselves representing values assumed by a signal to be recovered, the said data comprising a standard code (C_{N}) determining the standard of said vector, a code (C_{T}) showing to which type this vector belongs, and an index code (C_{I}(N,T)) differentiating the said vector from the other vectors of the same standard and same type, characterised in that it consists in:
- determining a set of points of the said space, the said points belonging to an isonorm of which the standard is given by the said standard code (C_{N}),
- determining a sub-set of points of the said set of points, the said points of said sub-set being defined by belonging to a type given by the said type code (C_{T}),
- determining the point of the space which belongs to said sub-set and which has said index code (C_{I}(N,T)),
- considering the components of the said vector in order to recover the value of the signal to be recovered.

## Patentansprüche

1. Verfahren zur Codierung von digitalen Daten, die durch Vektoren eines n-dimensionalen Raums dargestellt sind, dessen Komponenten für Werte stehen, die von einem zu codierenden Signal angenommen werden, dadurch gekennzeichnet, daß es darin besteht, jedem dieser Vektoren einen Code (C_{N}), der für seine Norm steht, einen Code (C_{T}) für die Zugehörigkeit zu einem Vektortyp, wobei jeder Typ durch ein gegebenes Verhältnis definiert ist, das zwischen den von den Komponenten der zu codierenden Vektoren angenommenen Werten bestehen kann, und einen Indexcode (C_{I}(N, T)) zuzuteilen, der den Vektor von den anderen Vektoren derselben Norm und desselben Typs unterscheidet.

2. Codierverfahren nach Anspruch 1, dadurch gekennzeichnet, daß es darin besteht, für die Definition jedes Typs Untereinheiten der Einheit der zu codierenden Vektoren derselben Norm zu bilden, wobei jede dieser Untereinheiten von Vektoren gebildet wird, deren Komponenten ein oder mehrere Multipletts umfassen, die vorbestimmte Merkmale aufweisen.

3. Codierverfahren nach Anspruch 1, dadurch gekennzeichnet, daß es darin besteht, für die Definition jedes Typs Untereinheiten der Einheit der zu codierenden Vektoren zu bilden, wobei jede der Untereinheiten von Vektoren gebildet wird, deren Komponenten ein oder mehrere Multipletts umfassen, deren Elemente sich voneinander nach einem vorbestimmten Verhältnis ableiten.

4. Codierverfahren nach Anspruch 1, dadurch gekennzeichnet, daß es darin besteht, für die Definition jedes Typs Untereinheiten der Einheit der zu codierenden Vektoren zu bilden, wobei jede der Untereinheiten von Vektoren gebildet wird, deren Komponenten ein oder mehrere Multipletts umfassen, deren Elemente untereinander gleich sind.

5. Codierverfahren nach Anspruch 4, wobei die zu codierenden Vektoren vierdimensional sind, dadurch gekennzeichnet, daß es darin besteht, für die Bildung dieses Typencodes fünf Typen von Untereinheiten auf die folgende Weise zu bilden:
- der erste Typ entspricht der Untereinheit der Vektoren, deren vier Komponenten gleich sind,
- der zweite Typ entspricht der Untereinheit der Vektoren, deren Komponenten zwei identische Komponentenpaare aufweisen,
- der dritte Typ entspricht der Untereinheit der Vektoren, deren Komponenten ein identisches Komponentenpaar und ein unterschiedliches Komponentenpaar aufweisen,
- der vierte Typ entspricht der Untereinheit der Vektoren, deren Komponenten ein Triplett von identischen Komponenten und eine unterschiedliche Komponente aufweisen, und
- der fünfte Typ entspricht der Untereinheit der Vektoren, deren Komponenten zwei und zwei unterschiedlich sind.

6. Decodierverfahren für digitale Daten, die für Komponenten eines Vektors eines n-dimensionalen Raums stehen, wobei diese Komponenten selbst für Werte stehen, die von einem wiederherzustellenden Signal angenommen werden, wobei diese Daten einen Normcode (C_{N}), der die Norm des Vektors bestimmt, einen Code (C_{T}) für die Zugehörigkeit des Vektors zu einem Vektortyp und einen Indexcode (C_{I}(N, T)) umfassen, der den Vektor von den anderen Vektoren derselben Norm und desselben Typs unterscheidet, dadurch gekennzeichnet, daß es darin besteht:
- eine Einheit von Punkten des Raums zu bestimmen, wobei diese Punkte einer Isonorm angehören, deren Norm von dem Normcode (C_{N}) vorgegeben wird,
- eine Untereinheit von Punkten der Einheit von Punkten zu bestimmen, wobei die Punkte der Untereinheit durch ihre Zugehörigkeit zu einem gegebenen Typ durch den Typencode (C_{T}) definiert sind,
- den Punkt des Raumes zu bestimmen, der der Untereinheit angehört und der den Indexcode (C_{I}(N, T)) besitzt,
- die Komponenten des Vektors zu betrachten, um den Wert des wiederherzustellenden Signals wiederherzustellen.
